(19) **Europäisches Patentamt / European Patent Office / Office européen des brevets**

(11) **EP 4 443 526 A1**

(12) **EUROPEAN PATENT APPLICATION**
published in accordance with Art. 153(4) EPC

(43) Date of publication:
**09.10.2024 Bulletin 2024/41**

(21) Application number: **22943231.5**

(22) Date of filing: **27.05.2022**

(51) International Patent Classification (IPC):
*H01L 33/52* $^{(2010.01)}$    *H10K 71/00* $^{(2023.01)}$

(52) Cooperative Patent Classification (CPC):
**H01L 33/52**

(86) International application number:
**PCT/CN2022/095752**

(87) International publication number:
**WO 2023/226033 (30.11.2023 Gazette 2023/48)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
• **Boe Technology Group Co., Ltd.**
  **Beijing 100015 (CN)**
• **BOE MLED Technology Co., Ltd.**
  **Beijing 100176 (CN)**

(72) Inventors:
• **LI, Jinpeng**
  **Beijing 100176 (CN)**
• **YANG, Zhifu**
  **Beijing 100176 (CN)**
• **ZHAI, Ming**
  **Beijing 100176 (CN)**

• **DONG, Enkai**
  **Beijing 100176 (CN)**
• **WANG, Ling**
  **Beijing 100176 (CN)**
• **WANG, Shuangjian**
  **Beijing 100176 (CN)**
• **QI, Jiacheng**
  **Beijing 100176 (CN)**
• **SUN, Liang**
  **Beijing 100176 (CN)**
• **ZHOU, Qiqi**
  **Beijing 100176 (CN)**
• **CHU, Yutian**
  **Beijing 100176 (CN)**
• **WANG, Le**
  **Beijing 100176 (CN)**

(74) Representative: **Lavoix**
  **Bayerstraße 83**
  **80335 München (DE)**

(54) **DISPLAY SUBSTRATE, MOLD ASSEMBLY, TILED DISPLAY MODULE AND DISPLAY DEVICE**

(57)     Provided are a display baseplate, a mould assembly, a spliced display module, and a display apparatus. The display baseplate includes a backplate (10), a plurality of light emitters (20) and an encapsulation layer (30). The backplate (10) includes a first main surface (11) and a second main surface (12) that are opposite to each other, and a plurality of side surfaces (13) connected to the first main surface (11) and the second main surface (12); a plurality of light emitters (20) are located on the first main surface (11), the encapsulation layer (30) is at least partially located on the first main surface (11) and covers the plurality of light emitters (20). The spliced display module includes a plurality of splicing units (100), the plurality of splicing units (100) each include a splicing frame (60) and a display baseplate, the display baseplate is fixed on the splicing frame (60) with the light emitters away from the splicing frame; and the splicing frames (60) of adjacent splicing units (100) are spliced together. The display apparatus includes a display baseplate or a spliced display module.

FIG.1

**Description**

**TECHNICAL FIELD**

The present disclosure relates to the field of display technologies, and in particular to a display baseplate, a mould assembly, a spliced display module and a display apparatus.

**BACKGROUND**

Mini-LED and Micro LED are a novel LED display technology derived from mini-spacing LEDs, which are also called sub-millimeter light-emitting diodes. Due to their good display effect, lightness, and thinness as well as high contrast and long life span and the like, they have noticeable tendency to use in the display field.

**SUMMARY**

The present disclosure provides a display baseplate, a mould assembly and method for manufacturing the display baseplate and a display apparatus.

According to a first aspect of embodiments of the present disclosure, there is provided a display baseplate, including:

a backplate, where the backplate includes a first main surface and a second main surface that are opposite to each other, and a plurality of side surfaces connected to the first main surface and the second main surface;
a plurality of light emitters located on the first main surface; and
an encapsulation layer, at least partially located on the first main surface and covering the plurality of light emitters.

In some embodiments, at least one side surface of the plurality of side surfaces is a selected side surface, and the encapsulation layer includes a first sub-encapsulation portion encapsulating the selected side surface.

In some embodiments, the first sub-encapsulation portion and a part, on the first main surface, of the encapsulation layer are integrated together.

In some embodiments, a side surface of the first sub-encapsulation portion is an inclined surface, an included angle between the inclined surface and the first main surface is an acute angle; or, the side surface of the first sub-encapsulation portion is perpendicular to the first main surface.

In some embodiments, the side surface of the sub-encapsulation portion is an inclined surface, and a distance D1 between a light emitter closest to the side surface of the first sub-encapsulation portion and an edge of the first sub-encapsulation portion satisfies the following relational formula:

$$D_1 \geq H * \tan(\arcsin \frac{1}{n}) + \frac{H}{\tan \theta}$$

wherein H refers to a thickness of a part, on the first main surface, of the encapsulation layer, n indicates a reflective index of the encapsulation layer, and θ indicates an included angle between the inclined surface and the first main surface;
in a case where the side surface of the first sub-encapsulation portion is perpendicular to the first main surface, a distance D2 between a light emitter closest to the first sub-encapsulation portion and the edge of the first sub-encapsulation portion satisfies the following relational formula:

$$D_2 \geq H * \tan(\arcsin \frac{1}{n})$$

wherein, H refers to a thickness of a part, on the first main surface, of the encapsulation layer, n indicates a reflective index of the encapsulation layer.

In some embodiments, when the side surface of the first sub-encapsulation portion is an inclined surface, the included angle between the inclined surface and the first main surface is greater than or equal to 85°.

In some embodiments, the display baseplate further includes a plurality of electrodes disposed on the first main surface, a connection wire at least partially disposed on the at least one selected side surface, and a drive circuit disposed on the second main surface; the plurality of electrodes are electrically connected to the plurality of light emitters, and the connection wire electrically connects the drive circuit with the electrodes.

In some embodiments, the display baseplate further includes a drive circuit disposed at an edge region of the second main surface, where the encapsulation layer further includes a second sub-encapsulation portion covering the drive circuit.

In some embodiments, the plurality of side surfaces are all selected side surfaces, the encapsulation layer includes a first sub-encapsulation portion covering all the selected side surfaces and the second sub-encapsulation portion is ring-shaped.

In some embodiments, the encapsulation layer is black.

According to a second aspect of embodiments of the present disclosure, there is provided a mould assembly for manufacturing a display baseplate; the display baseplate includes a backplate, a plurality of light emitters and an encapsulation layer, the backplate includes a first main surface and a second main surface that are opposite to each other, and a plurality of side surfaces connected to the first main surface and the second main surface; the plurality of light emitters are located on the first main surface; and the encapsulation layer is at least partially located on the first main surface and covers the plurality of light emitters;

the mould assembly includes:

> a first sub-mould, including a first mould body and an auxiliary structure, where the auxiliary structure is disposed at a side of the first mould body, and configured to fix the second main surface of the backplate to the first mould body; and
> a second sub-mould, including a second mould body, where an accommodation reservoir is disposed in the second mould body, the accommodation reservoir is configured to accommodate an encapsulation material for manufacturing the encapsulation layer; when the first sub-mould is fitted to the second sub-mould, an edge of the auxiliary structure is abutted against the second mould body to close the accommodation reservoir.

In some embodiments, the auxiliary structure includes a release film; or the auxiliary structure is a rigid structure.

In some embodiments, the auxiliary structure includes a flat plate portion and a boss structure located at a side of the flat plate portion away from the first mould body. An edge of the boss structure is located at an inner side of an edge of the flat plate portion; where the flat plate portion has a larger width than the accommodation reservoir, and the boss structure has a smaller width than the accommodation reservoir; where when the first sub-mould is fitted to the second sub-mould, the edge of the flat plate portion is abutted against the second mould body and the boss structure enters the accommodation reservoir.

In some embodiments, a drive circuit is disposed in an edge region of the second main surface; where a groove is disposed in an edge region of a surface of the auxiliary structure away from the first mould body and configured to enable an encapsulation material for manufacturing the encapsulation layer to partially enter between the groove and the second main surface of the backplate, so as to form a second sub-encapsulation portion covering the drive circuit.

In some embodiments, the groove is ring-shaped groove.

According to a third aspect of embodiments of the present disclosure, there is provided a method for manufacturing a display baseplate, which is applied to the above mould assembly. The width of the backplate is less than the width of the accommodation reservoir; and the manufacture method includes:

> fixing the second main surface of the backplate to a side of the auxiliary structure away from the first mould body and disposing a plurality of light emitters on the first main surface of the backplate;
> filling an encapsulation material for manufacturing the encapsulation layer in the accommodation reservoir of the second mould body;
> fitting the first sub-mould to the second sub-mould such that the edge of the auxiliary structure is abutted against the second mould body to close the accommodation reservoir, while the light emitters are immersed in the encapsulation material for manufacturing the encapsulation layer;
> performing vacuumizaiton on the accommodation reservoir, and then, heating the first sub-mould and the second sub-mould such that the encapsulation material for manufacturing the encapsulation layer is thermally solidified to form an encapsulation layer at least partially covering the light emitters; and
> releasing the first sub-mould and the second sub-mould to obtain the display baseplate.

According to a fourth aspect of embodiments of the present disclosure, there is provided a spliced display module. The spliced display module includes a plurality of splicing units. The plurality of splicing units include a splicing frame and the above display baseplate; the display baseplate is fixed on the splicing frame with the light emitters away from the splicing frame; and the splicing frames of adjacent splicing units are spliced together.

In some embodiments, a spacing between two adjacent light emitters in the display baseplate is a first spacing;

in two adjacent splicing units, a spacing between a light emitter close to the edge of the display baseplate in one splicing unit and a light emitter closest to the light emitter in another splicing unit is a second spacing, and the first spacing is basically equal to the second spacing.

In some embodiments, in the splicing units, an edge of the encapsulation layer is located at an inner side of an edge of the splicing frame, and an edge of the backplate is located at an inner side of the edge of encapsulation layer.

In some embodiments, the spacing between adjacent light emitters in the display baseplate is the first spacing; in two adjacent splicing units, a light emitter closest to the other splicing unit in one splicing unit is a first light emitter, and a light emitter closest to the first light emitter in the other splicing unit is a second light emitter; a minimum distance between the first light emitter and the edge of the backplate of the display baseplate where the first light emitter is located is a first distance; a minimum distance between the second light emitter and the edge of the backplate of the display baseplate where the second light emitter is located is a second distance; in the display baseplate where the first light emitter is located, a minimum distance between the edge of the backplate closest to the first light emitter and the edge of the encapsulation layer is a third distance; in the display baseplate where the second light emitter is located, a minimum distance between the edge of the backplate closest to the second light emitter and the edge of the encapsulation layer is a fourth distance;

in two adjacent splicing units, a size D of a splicing gap between adjacent edges of the two encapsulation layers satisfies the following relational formula:

$$D \geq d_1 - S_1 - A_1 - S_2 - A_2 - 2\delta$$

where $d_1$ is the first spacing, $S_1$ is the first distance, $S_2$ is the second distance, $A_1$ is the third distance, $A_2$ is the fourth distance, and $\delta$ is a maximum process deviation when thinning processing is performed on the side portion of the encapsulation layer; the sizes of the first spacing, the first distance, the second distance, the third distance, the fourth distance and the splicing gap are sizes in a same direction.

According to a fifth aspect of embodiments of the present disclosure, there is provided a display apparatus, including the above display baseplate, or the above spliced display module.

**BRIEF DESCRIPTION OF THE DRAWINGS**

FIG. 1 is a partial sectional view of a display baseplate according to some exemplary embodiments of the present disclosure.

FIG. 2 is a structural schematic diagram of a display baseplate according to some exemplary embodiments of the present disclosure.

FIG. 3 is a partial sectional view of another display baseplate according to some exemplary embodiments of the present disclosure.

FIG. 4 is a partial sectional view of yet another display baseplate according to some exemplary embodiments of the present disclosure.

FIG. 5 is a structural schematic diagram of yet another display baseplate according to some exemplary embodiments of the present disclosure.

FIG. 6 is a sectional view of a mould assembly for manufacturing a display baseplate according to some exemplary embodiments of the present disclosure.

FIG. 7 is a sectional view of another mould assembly for manufacturing a display baseplate according to some exemplary embodiments of the present disclosure.

FIG. 8 is a sectional view of yet another mould assembly for manufacturing a display baseplate according to some exemplary embodiments of the present disclosure.

FIG. 9 is a flowchart illustrating a method of manufacturing a display baseplate according to some exemplary embodiments of the present disclosure.

FIG. 10 is a partial sectional view of a spliced display module according to some exemplary embodiments of the present disclosure.

**DETAILED DESCRIPTION OF THE EMBODIMENTS**

Exemplary embodiments will be described in detail herein, with the illustrations thereof represented in the drawings. When the following descriptions involve the drawings, like numerals in different drawings refer to same or similar elements unless otherwise indicated. The embodiments described in the following examples do not represent all embodiments consistent with the present disclosure. Rather, they are merely examples of apparatuses and methods consistent with some aspects of the present disclosure as detailed in the appended claims.

The terms used in the present disclosure are for the purpose of describing particular examples only, and are not intended to limit the present disclosure. Terms determined by "a", "the" and "said" in their singular forms in the present disclosure and the appended claims are also intended to include plurality forms, unless clearly indicated otherwise in the context. It will also be understood that the term "and/or" as used herein refers to and includes any or all possible combinations of one or more of the associated listed items.

It is to be understood that, although the terms "first," "second," "third," and the like may be used in the present disclosure to describe various information, such information should not be limited to these terms. These terms are only used to distinguish one category of information from another. For example, without departing from the scope of the present disclosure, first information may be referred as second information; and similarly, the second information may also be referred as the first information. Depending on the context, the term "if" as used herein may be interpreted as "when" or "upon" or "in response to determining".

Embodiments of the present disclosure provide a display baseplate and a manufacture method, a mould assembly, a spliced display module, and a display apparatus. In combination with drawings, the display baseplate and the manufacture method, the mould assembly, the spliced display module, and the display apparatus in the embodiments of the present disclosure will be detailed below. In case of no conflicts, the features of the following embodiments can be mutually supplemented or combined.

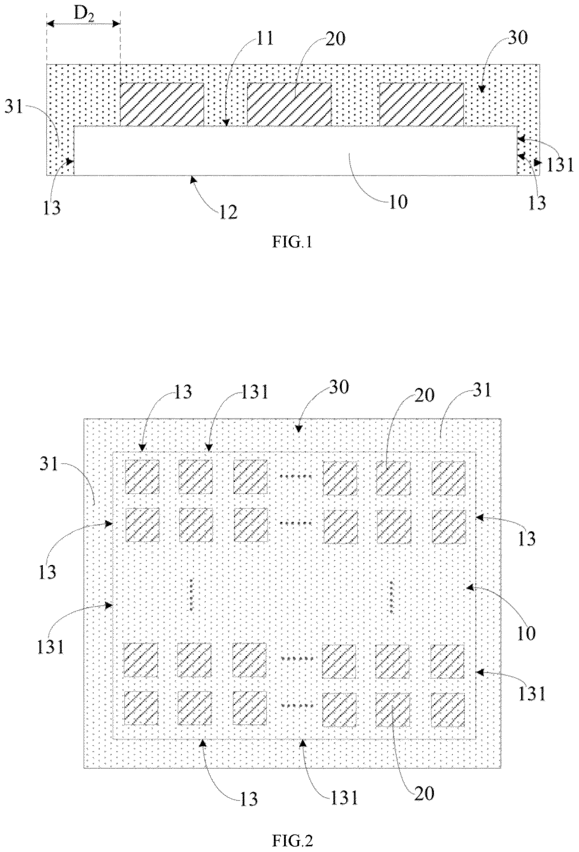

Some embodiments of the present disclosure provide a display baseplate. As shown in FIGs. 1 to 4, the display baseplate includes a backplate 10, a plurality of light emitters 20 and an encapsulation layer 30.

The backplate 10 includes a first main surface 11 and a second main surface 12 that are opposite to each other, and a plurality of side surfaces 13 connected to the first main surface 11 and the second main surface 12. The plurality of light emitters 20 are located on the first main surface 11. The encapsulation layer 30 is at least partially located on the first main surface 11, and covers the plurality of light emitters 20.

In the display baseplate provided by the embodiments of the present disclosure, the encapsulation layer 30 covers a plurality of light emitters 20 to protect the light emitters 20. Further, the encapsulation layer 30 helps to reduce a reflective index of environmental light incident on the baseplate and improve the display effect of the display baseplate.

In some embodiments, the backplate 10 includes a substrate and a drive circuit layer located at a side of the substrate. The substrate may be a flexible substrate, or a rigid substrate. The material of the flexible substrate may include one or more of polyimide, polyethylene terephthalate, polycarbonate, and organic resin. The material of the organic resin may include epoxy resin, triazine, silicon resin or polyimide or the like. The rigid substrate includes any one of glass substrate, quartz substrate, sapphire substrate and ceramic substrate; or include semiconductor substrate, for example, one of monocrystalline semiconductor substrate or polycrystalline semiconductor substrate with silicon or silicon carbide or the like as material, compound semiconductor substrate with silicon germanium or the like, and silicon on insulator (SOI) substrate.

The drive circuit layer, for example, includes structures such as a plurality of pixel circuits and a plurality of signal lines. The plurality of pixel circuits are in one-to-one correspondence with the plurality of light emitters 20, and the pixel circuits are electrically connected to the corresponding light emitters 20 and configured to drive the corresponding light emitters 20 to emit light.

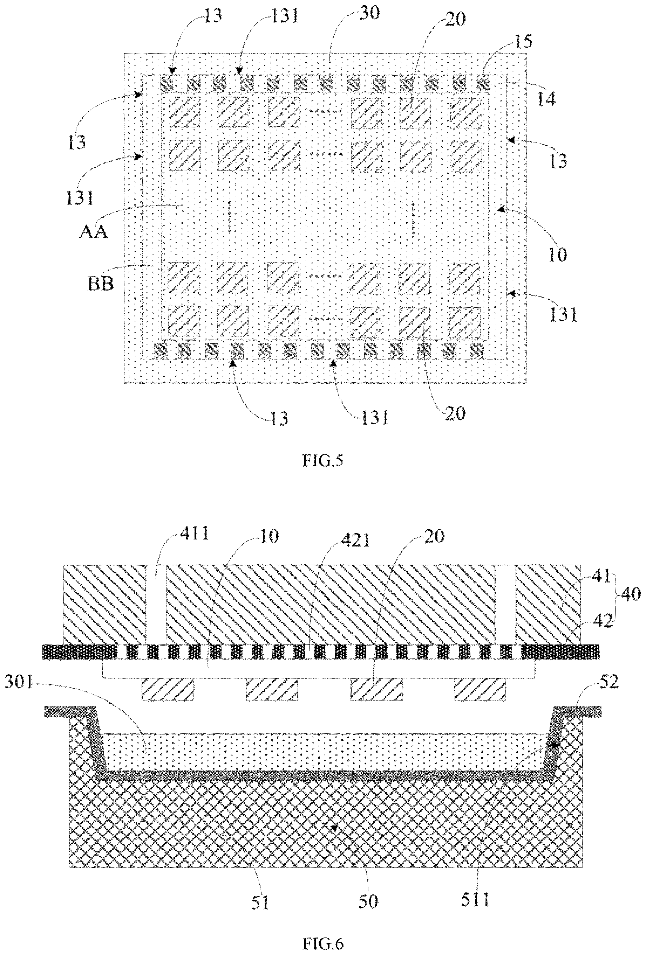

In some embodiments, at least one of a plurality of side surfaces 13 of the backplate 10 is a selected side surface 131. As shown in FIG. 5, the display baseplate further includes a plurality of electrodes 14 disposed on the first main surface 11, a connection wire 15 at least partially disposed on at least one selected side surface 131 and a drive circuit (not shown) disposed on the second main surface 12. The plurality of electrodes 14 are electrically connected to the plurality of light emitters 20, and the connection wire 15 electrically connects the drive circuit with the electrodes 14. The plurality of electrodes 14 are electrically connected to the plurality of light emitters 20 through the pixel circuits, and the plurality of electrodes 14 are electrically connected to the drive circuit disposed on the second main surface 12 through the connection wire 15. The drive circuit may be a drive chip or a flexible line board. The connection wire 15 may include three parts: one part is located in an edge region of the first main surface 11 and connected to the electrodes 14; one part is located on the selected side surface 131; and one part is located on the second main surface 12 and electrically connected to the drive circuit.

the connection wire 15 is at least partially disposed on the selected side surface 131 of the backplate 10, a plurality of electrodes on the first main surface 11 of the backplate 10 may be connected to the second main surface of the backplate through a plurality of connection wires 15. Thus, a plurality of electrodes 14 can be electrically connected to the drive chip or flexible circuit board disposed on the second main surface 12 through a plurality of connection wires 15. In this case, there is no need to dispose a binding region at an edge of the display baseplate and therefore, and the bezel of the display baseplate can be reduced, so as to obtain a display baseplate with an ultra-narrow bezel. The flexible circuit board may be bound to the second main surface 12 of the backplate by Chip on Glass (COG) process.

In one embodiment, as shown in FIG. 5, the display baseplate includes a display region AA and a surrounding region BB located on at least one side of the display region AA. In the embodiment shown in FIG. 5, the surrounding region BB surrounds the display region AA. A plurality of light emitters 20 are disposed in the display region AA of the display baseplate, and a plurality of electrodes 14 are disposed in the surrounding region BB of the display baseplate. An edge region of the backplate may be located in the surrounding region BB.

In some embodiments, the light emitters 20 include but not limited to organic light-emitting diodes (OLED), mini organic light-emitting diodes (mini LED), micro organic light-emitting diodes (micro LED) and the like.

In some embodiments, the plurality of light emitters 20 are partitioned into a plurality of pixel units, each of which includes at least three light emitters 20 of different luminous colors. At least three light emitters 20 of different luminous colors include, for example, a first-color light emitter, a second-color light emitter and a third-color light emitter, where the first color, the second color and the third color are three primary colors, for example, red, green and blue.

In some embodiments, the first main surface 11 and the second main surface 12 of the backplate 10 are shaped like, for example, rectangle. The backplate 10 includes four side surfaces 13. In other embodiments, the first main surface 11 and the second main surface 12 of the backplate 10 may be in another shape such as pentagon or hexagon.

In some embodiments, the part of the encapsulation layer 30 on the first main surface 11 covers a plurality of light emitters 20 and fills a gap region between adjacent light emitters 20 synchronously. In the part of the encapsulation layer 30 on the first main surface 11, a part covering a plurality of light emitters 20 may have a smaller thickness than a part filling the gap region between adjacent light emitters 20, such that a surface of the encapsulation layer 30 is entirely basically flat. Illustratively, an encapsulation material may be firstly coated on the first main surface 11 of the backplate 10 and then the surface of the encapsulation material is ground to ensure the surface of the encapsulation layer 30 is entirely basically flat.

In some embodiments, as shown in FGIs. 1 to 4, at least one of a plurality of side surfaces 13 is the selected side surface 131, and the encapsulation layer 30 includes a first sub-encapsulation portion 31 encapsulating the selected side surface 131. The first sub-encapsulation portion 31 can protect the selected side surface 131 of the backplate 10. In the embodiments shown in FIGS. 1 to 4, each side surface 13 of the backplate 10 is the selected side surface 131, that is, the encapsulation layer 30 wraps each side surface 13 of the backplate 10. The first sub-encapsulation portion 31 can protect the part of the connection wire 15 located on the selected side surface 131 and achieve electric insulation and prevention against water oxygen corrosion. In this way, the problems of external damage, peeling-off, breakage and oxidation of a plurality of connection wires 15 can be avoided.

In some embodiments, the first sub-encapsulation portion 31 and a part of the encapsulation layer 30 on the first main surface 11 are integrated, that is, individual parts of the encapsulation layer 30 are manufactured with a same material at the same time, helping simplify the manufacture process of the encapsulation layer 30.

In some embodiments, when the display baseplate is manufactured, after the manufacture process of the encapsulation layer is completed, if a thickness of the first sub-encapsulation portion 31 encapsulating the backplate 10 (a size of the first sub-encapsulation portion 31 in a direction parallel to the first main surface 11) is excessively large, a size of a splicing gap when the display baseplate is used to splice a display module is also excessively large. In this case, the side portion of the first sub-encapsulation portion 31 can be thinned. In some embodiments, the first sub-encapsulation portion 31 can be thinned by laser process, grinding process or knife wheel cutting. After the side portion of the first sub-encapsulation portion 31 is thinned, the side surface of the first sub-encapsulation portion 31 may be perpendicular to the first main surface 11 or inclined.

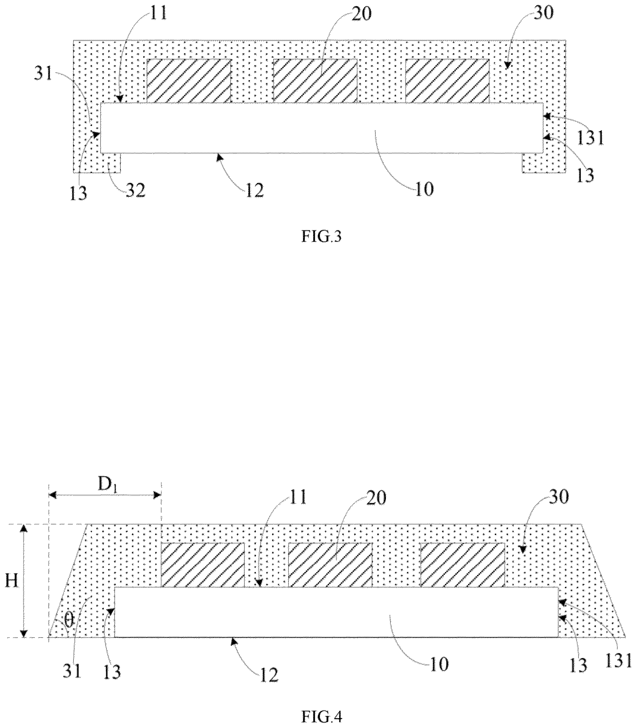

In some embodiments, as shown in FIGs. 1 and 3, the side surface of the first sub-encapsulation portion 31 is perpendicular to the first main surface 11.

In a case where the side surface of the first sub-encapsulation portion 31 is perpendicular to the first main surface 11, a distance D2 from the light emitter 20 closest to the first sub-encapsulation portion 31 to an edge of the first sub-encapsulation portion 31 satisfies the following relational formula:

$$D_2 \geq H * \tan(\arcsin \frac{1}{n})$$

where H refers to a thickness of the part of the encapsulation layer on the first main surface, and more exactly, a maximum thickness of the part of the encapsulation layer on the first main surface; n refers to a reflective index of the encapsulation layer.

In this way, the light emitted by the light emitter 20 closest to the first sub-encapsulation portion 31 is emitted from the surface of the encapsulation layer 30 away from the first main surface 11, preventing the light from emitting from the side surface of the first sub-encapsulation portion 31. When the display baseplate is used for a spliced screen, poor visual feel at the splicing gap can be avoided.

In some embodiments, as shown in FIG. 4, the side surface of the first sub-encapsulation portion 31 is an inclined surface, and an included angle θ between the inclined surface and the first main surface 11 is an acute angle.

In a case where the side surface of the sub-encapsulation portion 31 is an inclined surface, a distance D1 from the light emitter closest to the side surface of the first sub-encapsulation portion 31 to an edge of the first sub-encapsulation portion 31 satisfies the following relational formula:

$$D_1 \geq H * \tan(\arcsin\frac{1}{n}) + \frac{H}{\tan\theta}$$

where H refers to a thickness of the part of the encapsulation layer on the first main surface, n indicates a reflective index of the encapsulation layer, and θ indicates an included angle between the inclined surface and the first main surface 11. The edge of the first sub-encapsulation portion 31 refers to a position of the first sub-encapsulation portion 31 having a largest distance from the backplate 10.

In this way, the light emitted by the light emitter 20 closest to the first sub-encapsulation portion 31 is emitted from the surface of the encapsulation layer 30 away from the first main surface 11, preventing the light from emitting from the side surface of the first sub-encapsulation portion 31. In a case where the display baseplate is used for splicing a display module, poor visual feel at the splicing gap can be avoided.

In some embodiments, in a case where the thickness H and the reflective index n of the encapsulation layer 30 and the included angle θ between the side surface of the sub-encapsulation portion 31 and the first main surface 11 take different values, the minimum distance from the light emitter closest to the side surface of the first sub-encapsulation portion 31 to the edge of the first sub-encapsulation portion 31 can be expressed as in Table 1:

Table 1

| H | n | $D_{1min}$ in a case where θ=90° | $D_{2min}$ in a case where θ=85° | $D_{2min}$ in a case where θ=80° |
|---|---|---|---|---|
| 250 μm | 1 .6 | 200μm | 222μm | 244μm |
| 200 μm | 1 .6 | 160μm | 178μm | 195μm |
| 175 μm | 1 .6 | 140μm | 155μm | 171μm |
| 175 μm | 1 .5 | 158μm | 173μm | 189μm |
| 150 μm | 1 .6 | 120μm | 133μm | 146μm |
| 150 μm | 1 .5 | 135μm | 148μm | 161μm |
| 125 μm | 1 .6 | 100μm | 111μm | 122μm |
| 125 μm | 1 .5 | 112μm | 123μm | 134μm |
| 125 μm | 1 .4 | 125μm | 136μm | 147μm |

From Table 1, it can be seen that, in a case where the thickness H and the reflective index n of the encapsulation layer 30 are given, the smaller the included angle θ between the side surface of the sub-encapsulation portion 31 and the first main surface 11 is, the larger the minimum distance from the light emitter closest to the side surface of the first sub-encapsulation portion 31 to the edge of the first sub-encapsulation portion 31 is; in a case where the reflective index n of the encapsulation layer 30 and the included angle θ between the side surface of the sub-encapsulation portion 31 and the first main surface 11 are given, the larger the thickness H of the encapsulation layer 30, the larger the minimum distance from the light emitter closest to the side surface of the first sub-encapsulation portion 31 to the edge of the first sub-encapsulation portion 31 is; in a case where the thickness H of the encapsulation layer 30 and the included angle θ between the side surface of the sub-encapsulation portion 31 and the first main surface 11 are given, the larger the reflective index n of the encapsulation layer 30 is, the smaller the minimum distance from the light emitter closest to the side surface of the first sub-encapsulation portion 31 to the edge of the first sub-encapsulation portion 31 is.

In some embodiments, in a case where the side surface of the first sub-encapsulation portion 31 is an inclined surface, the included angle between the inclined surface and the first main surface 11 is greater than or equal to 85°. In this way, the following problem can be avoided: in a case where the included angle θ between the inclined surface of the first sub-encapsulation portion 31 and the first main surface 11 is too small, the distance D1 from the light emitter closest to the side surface of the first sub-encapsulation portion 31 to the edge of the first sub-encapsulation portion 31 will be too large, which further results in a large distance between adjacent light emitters of two adjacent display baseplates when the display baseplates are used for spliced screen, which is greater than a spacing between adjacent light emitters inside the display baseplate, thus affecting the display effect of the spliced region of the spliced screen. In some embodiments, the included angle θ between the inclined surface and the first main surface 11 is 85°, 86°, 87°, 88°, 89°, 90° or the like.

In some embodiments, as shown in FIG. 3, the encapsulation layer 30 further includes a second sub-encapsulation portion 32 covering the drive circuit on the second main surface 12. The second sub-encapsulation portion 32 can protect the drive circuit and achieve electric insulation and prevention against water oxygen corrosion. In this way, the problems of external damage, peeling-off, breakage and oxidation of the drive circuit can be avoided.

In some embodiments, the first sub-encapsulation portion 31, the second sub-encapsulation portion 32 and the part of the encapsulation layer 30 on the first main surface 11 are integrated together.

In some embodiments, a width of the second sub-encapsulation portion 32 is greater than or equal to a width of the drive circuit on the second main surface 12, such that the second sub-encapsulation portion 32 can achieve better protection on the drive circuit. Generally, the width of the drive circuit on the second main surface 12 is about $2\mu m$ to $3\mu m$, inclusive, and the width of the second sub-encapsulation portion 32 may be greater than or equal to $3\mu m$.

In some embodiments, as shown in FIG. 3, a plurality of side surfaces 13 are all the selected side surfaces 131. The encapsulation layer 30 includes the first sub-encapsulation portion 31 encapsulating each selected side surface 131. The second sub-encapsulation portion 32 is shaped like ring. When the encapsulation layer 30 is manufactured, an encapsulation material for manufacturing the encapsulation layer 30 flows to the second main surface 12 of the backplate 10 through the side surfaces 13 of the backplate 10, and the part of the encapsulation material encapsulating the side surface 13 is formed into the first sub-encapsulation portion 31 and the part flowing to the second main surface 12 of the backplate 10 is formed into the second sub-encapsulation portion 32. In a case where each side surface 13 of the backplate 10 is the selected side surface 131, the second sub-encapsulation portion 32 formed on the second main surface 12 of the backplate 10 is shaped like ring. In the case where the display baseplate is used for splicing a display module, the display baseplate is to be mounted on a splicing frame. Since the second sub-encapsulation portion 32 is ring-shaped, when the display baseplate is mounted on the splicing frame, the second sub-encapsulation portion 32 is in contact with the splicing frame to ensure the display baseplate is stably mounted on the splicing frame, avoiding tilting of the display baseplate.

In some embodiments, the encapsulation layer 30 may further serve as a light-adjusting layer to adjust transmittances of the incident light and emitted light. In this way, the encapsulation layer 30 can effectively reduce the reflective index of environmental light incident on the display baseplate, and improve the display effect of the display baseplate. In some embodiments, the encapsulation layer 30 is black, for example, the material of the encapsulation layer 30 may be black silica gel or black resin or the like. A maximum thickness of the encapsulation layer 30 may be greater than or equal to 250 microns. The transmittance of the encapsulation layer 30 is selected in such a way that most light in the light emitted by the light emitters 20 when the display baseplate is in a display state can be passed through the encapsulation layer 30 while a part of the environmental light incident on the display baseplate when the display baseplate is in non-display state can be absorbed by the encapsulation layer 30 so as to reduce the reflective index of the environmental light.

In some embodiments, a plurality of alignment marks are disposed on the second main surface 12 of the backplate 10. The plurality of alignment marks include marks for performing alignment in the COG process. The alignment marks used for performing alignment in the COG process may include a pre-press mark and a present press mark, where the pre-press mark is used to perform alignment for fixing an anisotropic conductive adhesive to the second main surface 12 of the backplate 10 and the present press mark is used to perform alignment for fixing the flexible circuit board on the anisotropic conductive adhesive, and hence, the flexible circuit board can be bound to the backplate through the anisotropic conductive adhesive.

The plurality of alignment marks may also include a mark for performing alignment at the time of performing thinning processing on the side portion of the encapsulation layer 30. The mark may also be used to perform alignment when a plurality of display baseplate are spliced, that is, one alignment mark further serves in different processes, which can reduce the number of alignment marks.

Some embodiments of the present disclosure further provide a mould assembly for manufacturing a display baseplate. The display baseplate is the display baseplate mentioned in any one of the above embodiments.

As shown in FIGs. 6 to 8, the mould assembly includes a first sub-mould 40 and a second sub-mould 50.

The first sub-mould 40 includes a first mould body 41 and an auxiliary structure 42 and the auxiliary structure 42 is disposed at a side of the first mould body 41 and configured to fix the second main surface 12 of the backplate 10 to the first mould body 41. The second sub-mould 50 includes a second mould body 51 and an accommodation reservoir 511 is disposed in the second mould body 51. The accommodation reservoir 511 is used to accommodate an encapsulation material 301 for manufacturing the encapsulation layer 30. When the first sub-mould 40 is fitted to the second sub-mould 50, an edge of the auxiliary structure 42 is abutted against the second mould body 51 to close the accommodation reservoir 511.

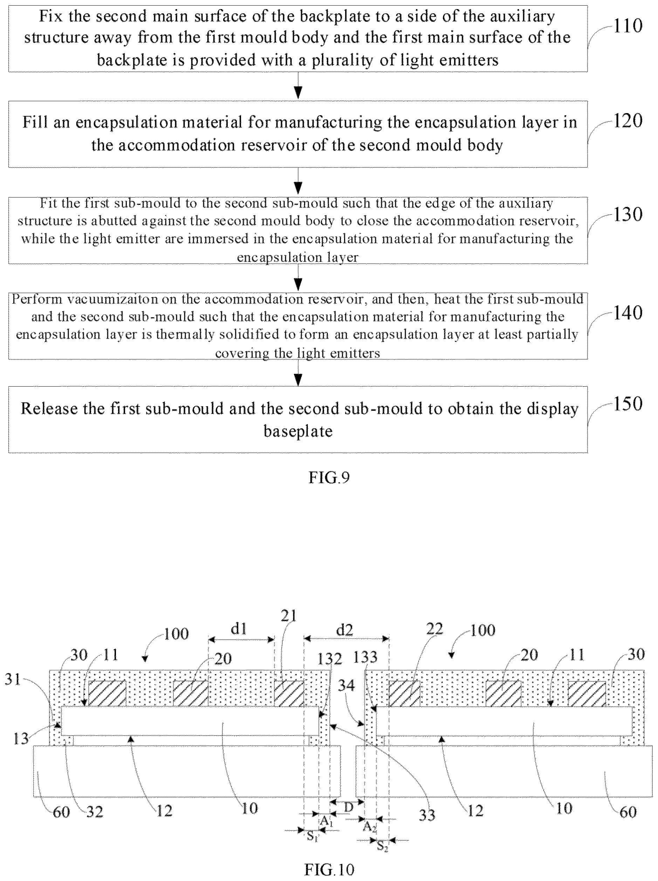

Some embodiments of the present disclosure further provide a method for manufacturing a display baseplate, which is applied to the above mould assembly. The backplate 10 has a smaller width than the accommodation reservoir 511. As shown in FIG. 9, the manufacture method may include steps 110 to 150.

In step 110, the second main surface of the backplate is fixed to a side of the auxiliary structure away from the first mould body and the first main surface of the backplate is provided with a plurality of light emitters.

Before step 110 is performed, a plurality of light emitters 20 are disposed on the first main surface of the backplate 10.

In this step, the second main surface 12 of the backplate 10 is fixed to the first sub-mould 40 through the auxiliary structure 42. The width of the auxiliary structure 42 is greater than the width of the backplate 10. After the backplate 10 is fixed on the auxiliary structure 42, an edge of the backplate 10 is located at an inner side of the edge of the auxiliary structure 42, and there is a distance between the edge of all positions of the backplate 10 and the edge of the auxiliary structure 42.

In some embodiments, as shown in FIGs. 6 to 8, the auxiliary structure 42 is provided with a plurality of through holes 421 penetrating through the auxiliary structure 42. A plurality of through holes 411 penetrating through the first sub-mould body 41 are disposed in the first mould body 41, and the through holes 411 of the first sub-mould body 41 are in communication with the through holes 421 of the auxiliary structure 42. Vacuumization can be performed through the through holes 411, such that the auxiliary structure 42 is fixed, by vacuum adsorption, onto a surface of the first mould body 41 close to the auxiliary structure 42.

In some embodiments, the auxiliary structure 42 includes a release film. In a case where the auxiliary structure 42 is a release film, after the display baseplate is manufactured, the release film may be separated from the first mould body 41 together with the display baseplate. In this case, a new release film may be provided for the first sub-mould 40 to manufacture a next display baseplate. The material of the release film may be a weakly viscous material, which can be easily separated from the first mould body 41.

In some embodiments, the material of the auxiliary structure 42 may be a viscous material; the surface of the auxiliary structure 42 facing toward the first mould body 41 is fixed to the first mould body by vacuum adsorption; the surface of the auxiliary structure 42 away from the first mould body is bonded to the second surface of the backplate 10, so that the backplate 10 can be fixed to the first sub-mould 40.

In some embodiments, the auxiliary structure 42 is a rigid structure. In a case where the auxiliary structure is a rigid structure, the backplate 10 can be fixed to the first mould body 41 by vacuum adsorption. After the display baseplate is manufactured, the auxiliary structure 42 can be reused.

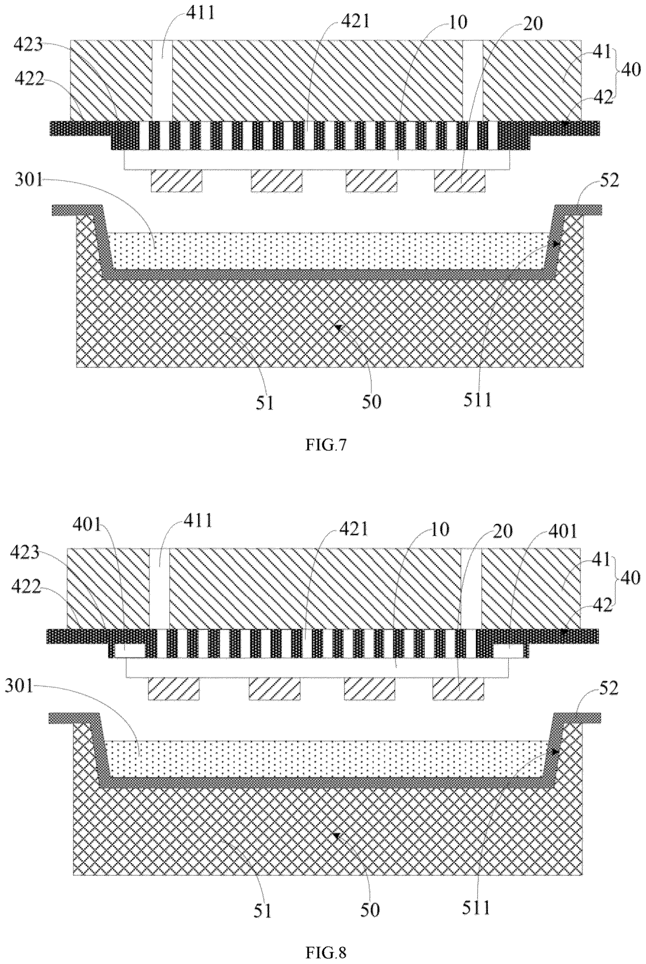

In some embodiments, as shown in FIGs. 7 and 8, the auxiliary structure 42 includes a flat plate portion 422 and a boss structure 423 disposed at a side of the flat plate portion 422 away from the first mould body 41. An edge of the boss structure 423 is located at an inner side of the edge of the flat plate portion 422. The flat plate portion 422 has a larger width than the accommodation reservoir 511, and the boss structure 423 has a smaller width than the accommodation reservoir 511.

In step 120, an encapsulation material for manufacturing the encapsulation layer is filled in the accommodation reservoir of the second mould body.

In this step, the encapsulation material 301 for manufacturing the encapsulation layer may be in liquid state. After the encapsulation material 301 for manufacturing the encapsulation layer is filled in the accommodation reservoir 511, a distance from a surface of the encapsulation material 301 for manufacturing the encapsulation layer to a bottom surface of the accommodation reservoir 511 is less than a depth of the accommodation reservoir 511. When the backplate 10 and the light emitters 20 are immersed in the encapsulation material 301 for manufacturing the encapsulation layer, only a small amount of encapsulation material 301 for manufacturing the encapsulation layer 30 flows out of the accommodation reservoir 511.

In step 130, the first sub-mould is fitted to the second sub-mould such that the edge of the auxiliary structure is abutted against the second mould body to close the accommodation reservoir, while the light emitters are immersed in the encapsulation material for manufacturing the encapsulation layer.

In this step, firstly, the first sub-mould 40 is placed above the second sub-mould 50, such that the light emitters 20 disposed on the backplate 10 on the first sub-mould 40 face toward the accommodation reservoir 511; next, the first sub-mould 40 is fitted to the second sub-mould 50, and the edge of the auxiliary structure 42 is abutted against the edge of the second mould body 51 circling the accommodation reservoir 511, and thus, the auxiliary structure 42, the backplate 10 and the second mould body 51 cooperatively close the accommodation reservoir 511. Since the width of the backplate 10 is less than the width of the accommodation reservoir 511, the backplate 10 can be immersed in the encapsulation material 301 for manufacturing the encapsulation layer in the accommodation reservoir 511 such that the encapsulation material 301 for manufacturing the encapsulation layer is partially located at the side surfaces of the backplate 10.

In some embodiments, as shown in FIGs. 7 and 8, when auxiliary structure 42 includes the flat plate portion 422 and the boss structure 423 disposed at a side of the flat plate portion 422 away from the first mould body 41, the backplate 10 has a smaller width than the boss structure 423. When the first sub-mould 40 is fitted to the second sub-mould 50, the edge of the flat plate portion 422 is abutted against the second mould body 51 and the boss structure 423 enters the accommodation reservoir 511. The encapsulation material 301 for manufacturing the encapsulation layer 30 is partially located at the region of the boss structure 423 circling the backplate 10. This part of encapsulation material is later formed into the first sub-encapsulation portion 31 of the encapsulation layer 30. Since the auxiliary structure 42 includes the flat plate portion 422 and the boss structure 423, the flat plate portion 422 is abutted against the second mould body 51 to close the accommodation reservoir 511, and the boss structure 423 can enable partial encapsulation material 301 to be better gathered at the side surfaces of the backplate 10. As a result, the first sub-encapsulation portion 31 formed on the side surface of the backplate can be formed better, helping protect the connection wire on the sides surface of the backplate.

In some embodiments, a distance between an edge of the boss structure 423 and an edge of the backplate 10 may be greater than or equal to 0.3mm, such that the part of the formed encapsulation layer 30 at the side surfaces of the backplate 10 has a size of greater than or equal to 0.3mm in a direction parallel to the first main surface 11. Thus, when thinning processing is performed on the encapsulation layer at the side portion of the backplate 10, the connection wire at the side surface of the backplate will not be damaged in spite of any process deviation.

In some embodiments, as shown in FIG. 8, a groove 401 are disposed in an edge region of the surface of the auxiliary structure 42 away from the first mould body 41 and configured to enable partial encapsulation material 301 for manufacturing the encapsulation layer to enter between the groove 401 and the second main surface 12 of the backplate 10, so as to form the second sub-encapsulation portion 32 covering the drive circuit. An outer edge of the groove 401 is located at the outer side of the edge of the backplate 10 and an inner edge of the groove 401 is located at the inner side of the edge of the backplate 10. After the backplate 10 is immersed in the encapsulation material 300 for manufacturing the encapsulation layer, the partial encapsulation material will enter a space between the groove 401 and the backplate 10, and this part of encapsulation material will be later formed into the second sub-encapsulation portion 32. The second sub-encapsulation portion 32 covers the drive circuit disposed on the second main surface 12 of the backplate 10.

In some embodiments, the groove 401 is a ring-shaped groove. In this way, the second sub-encapsulation portion 32 of the encapsulation layer 30 is ring-shaped, and the ring-shaped second sub-encapsulation portion 32 is located at the edge region of the second main surface 12 of the backplate 10.

In some embodiments, as shown in FIG. 8, in a case where the auxiliary structure 42 includes the flat plate portion 422 and the boss structure 423, the groove 401 are disposed at the edge region of the boss structure 423.

In step 140, vacuumizaiton is performed on the accommodation reservoir, and then, the first sub-mould and the second sub-mould are heated such that the encapsulation material for manufacturing the encapsulation layer is thermally solidified to form an encapsulation layer at least partially covering the light emitters.

In this step, vacuumization is performed on the accommodation reservoir 511 to suck out most of the air in the accommodation reservoir 511 so as to prevent the air from being mixed in the encapsulation layer 301 for manufacturing the encapsulation layer 30 and thus avoid presence of air bubbles in the formed encapsulation layer 30. This is because the light emitted by the light emitters 20 will change its path when passing through the air bubbles in the encapsulation layer 30, thus affecting the display effect of the display baseplate.

In step 150, the first sub-mould and the second sub-mould are released to obtain the display baseplate.

In some embodiments, as shown in FIGs. 6 to 8, the second sub-mould further includes a release film 52, which is partially attached to the bottom surface and the side surface of the accommodation reservoir 511 and partially located at the top of the second mould body 51. When the first sub-mould 40 is fitted to the second sub-mould 50, the auxiliary structure 42 is abutted against the part of the release film 52 on the top of the second mould body 51. The release film 52 is disposed to facilitate separation between the display baseplate and the second sub-mould 50.

In some embodiments, after step 150, the method of manufacturing the display baseplate further includes: performing thinning processing on the part of the encapsulation layer 30 at the side portion of the backplate 10. In some embodiments, the thinning processing can be performed by laser process, grinding process or knife wheel cutting.

Some embodiments of the present disclosure further provide a spliced display module. The spliced display module includes a plurality of splicing units 100 as shown in FIG. 10. The splicing units 100 include a splicing frame 60 and the display baseplate described in any one of the above embodiments. The display baseplate is fixed on the splicing frame 60 while the light emitters 20 are away from the splicing frame 60; the splicing frames 60 of adjacent splicing units 100 are spliced together.

In some embodiments, a spacing between two adjacent light emitters 20 in the display baseplate is a first spacing d1; in two adjacent splicing units 100, a spacing between a light emitter 20 close to the edge of the display baseplate in one splicing unit 100 and a light emitter closest to the light emitter 20 in another splicing unit 100 is a second spacing d2, and the first spacing d1 is basically equal to the second spacing d2. The spacing between adjacent light emitters 20 may be a spacing between adjacent side surfaces of two adjacent light emitters 20. The first spacing is basically equal to the second spacing, which means the first spacing is equal to the second spacing or a difference between the first spacing and the second spacing is very small, which is, for example, within a predetermined value range. By enabling the first spacing and the second spacing to be basically equal, the display effects at all positions of the spliced display module are made more consistent, helping to improve the use experience of the users.

In some embodiments, as shown in FIG. 10, in the splicing units 100, the edge of the encapsulation layer 30 is located at an inner side of the edge of the splicing frame 60, and the edge of the backplate 10 is located at an inner side of the edge of the encapsulation layer 30. Since the edge of the backplate 10 is located at an inner side of the edge of the encapsulation layer 30 and the edge of the encapsulation layer 30 is located at an inner side of the edge of the splicing frame 60, when thinning processing is performed on the side portion of the encapsulation layer, the connection wire disposed at the side surface of the backplate 10 can be protected against any damage arising due to process error. Further, it can be guaranteed that there is a gap between adjacent encapsulation layers after adjacent splicing frames are spliced together, so as to avoid mutual influence of adjacent encapsulation layers 30. Furthermore, since the edge of the backplate 10 is located at an inner side of the edge of the encapsulation layer 30 and the edge of the encapsulation layer 30 is located at an inner side of the edge of the splicing frame 60, in two adjacent splicing units 100, a spacing between two splicing frames 60 is less than a spacing between two encapsulation layers 30 and the spacing between two encapsulation layers 30 is less than a spacing between two backplates 10.

In some embodiments, as shown in FIG. 10, the spacing between adjacent light emitters 20 in the display baseplate is the first spacing d1; in two adjacent splicing units 100, a light emitter 20 closest to the other splicing unit 100 in one splicing unit 100 is a first light emitter 21, and a light emitter closest to the first light emitter 21 in the other splicing unit 100 is a second light emitter 22. A minimum distance between the first light emitter 21 and the edge 312 of the backplate 10 of the display baseplate where the first light emitter is located is a first distance S1; a minimum distance between the second light emitter 22 and the edge 133 of the backplate of the display baseplate where the second light emitter is located is a second distance S2; in the display baseplate where the first light emitter 21 is located, a minimum distance between the edge 132 of the backplate 10 closest to the first light emitter 21 and the edge 33 of the encapsulation layer 30 is a third distance A1; in the display baseplate where the second light emitter 22 is located, a minimum distance between the edge 133 of the backplate 10 closest to the second light emitter 22 and the edge 34 of the encapsulation layer 30 is a fourth distance A2.

In two adjacent splicing units 100, a size D of a splicing gap between adjacent edges of the two encapsulation layers 30 satisfies the following relational formula:

$$D \geq d_1 - S_1 - A_1 - S_2 - A_2 - 2\delta$$

where $d_1$ is the first spacing, $S_1$ is the first distance, $S_2$ is the second distance, $A_1$ is the third distance, $A_2$ is the fourth distance, and $\delta$ is a maximum process deviation when thinning processing is performed on the side portion of the encapsulation layer; the sizes of the first spacing, the first distance, the second distance, the third distance, the fourth distance and the splicing gap are sizes in a same direction.

Some embodiments of the present disclosure further provide a display apparatus, including the display baseplate described in any one of the above embodiments.

In some embodiments, the display apparatus further includes a casing in which the display baseplates are embedded.

The display apparatus provided by the embodiments of the present disclosure may be any proper display apparatus, including but not limited to: smart phone, tablet computer, television, display, laptop computer, digital photo frame, navigator, electronic book and any other products or components having display function.

Some embodiments of the present disclosure further provide another display apparatus, including the spliced display module described in any one of the above embodiments.

In some embodiments, the display apparatus further includes a casing in which the spliced display module is embedded.

The display apparatus provided by the embodiments of the present disclosure may be any proper display apparatus, including but not limited to: smart phone, tablet computer, television, display, laptop computer, digital photo frame, navigator, electronic book and any other products or components having display function.

It will be noted that in the accompanying drawings, for illustration clarity, the sizes of the layers and regions may be exaggerated. Furthermore, it may be understood that when an element or layer is referred to as being "on" another element or layer, such element or layer may be directly on the another element or layer or there is an intermediate layer therebetween. Further, it is understood that when an element or layer is referred to as being "under" another element or layer, such element or layer may be directly under the another element or layer, or one or more intermediate elements or layers are present therebetween. In addition, it may also be understood that when a layer or element is referred to as being between two layers or elements, such layer or element may be a sole layer between the two layers or elements, or one or more intermediate layers or elements are present. Similar reference signs in the descriptions indicate similar elements.

Other implementations of the present disclosure will be apparent to a person skilled in the art from consideration of the specification and practice of the present disclosure herein. The present disclosure is intended to cover any variations, uses, modification or adaptations of the present disclosure that follow the general principles thereof and include common knowledge or conventional technical means in the related art that are not disclosed in the present disclosure. The specification and examples are considered as exemplary only, with a true scope and spirit of the present disclosure being indicated by the following claims.

It is to be understood that the present disclosure is not limited to the precise structure described above and shown in the accompanying drawings, and that various modifications and changes may be made without departing from the scope thereof. The scope of the present disclosure is limited only by the appended claims.

**Claims**

1. A display baseplate, comprising:

   a backplate, wherein the backplate comprises a first main surface and a second main surface that are opposite to each other, and a plurality of side surfaces connected to the first main surface and the second main surface;
   a plurality of light emitters on the first main surface; and
   an encapsulation layer, at least partially on the first main surface and covering the plurality of light emitters.

2. The display baseplate according to claim 1, wherein at least one side surface of the plurality of side surfaces is a selected side surface, and the encapsulation layer comprises a first sub-encapsulation portion encapsulating the selected side surface.

3. The display baseplate according to claim 2, wherein the first sub-encapsulation portion and a part, on the first main surface, of the encapsulation layer are integrated together.

4. The display baseplate according to claim 2, wherein a side surface of the first sub-encapsulation portion is an inclined surface, an included angle between the inclined surface and the first main surface is an acute angle; or wherein the side surface of the first sub-encapsulation portion is perpendicular to the first main surface.

5. The display baseplate according to claim 4, wherein the side surface of the sub-encapsulation portion is an inclined surface, and a distance D1 between a light emitter closest to the side surface of the first sub-encapsulation portion and an edge of the first sub-encapsulation portion satisfies the following relational formula:

$$D_1 \geq H * \tan(\arcsin\frac{1}{n}) + \frac{H}{\tan\theta}$$

   wherein H refers to a thickness of a part, on the first main surface, of the encapsulation layer, n indicates a reflective index of the encapsulation layer, and $\theta$ indicates an included angle between the inclined surface and the first main surface; or
   wherein the side surface of the first sub-encapsulation portion is perpendicular to the first main surface, a distance D2 between a light emitter closest to the first sub-encapsulation portion and the edge of the first sub-encapsulation portion satisfies the following relational formula:

$$D_2 \geq H * \tan(\arcsin\frac{1}{n})$$

   wherein, H refers to a thickness of a part, on the first main surface, of the encapsulation layer, n indicates a reflective index of the encapsulation layer.

6. The display baseplate according to claim 4, wherein when the side surface of the first sub-encapsulation portion is an inclined surface, the included angle between the inclined surface and the first main surface is greater than or equal to 85°.

7. The display baseplate according to claim 2, further comprising a plurality of electrodes disposed on the first main surface, a connection wire at least partially disposed on the at least one selected side surface, and a drive circuit disposed on the second main surface, wherein the plurality of electrodes are electrically connected to the plurality of light emitters, and the connection wire electrically connects the drive circuit with the electrodes.

8. The display baseplate according to claim 1, further comprising a drive circuit disposed at an edge region of the second main surface, wherein the encapsulation layer further includes a second sub-encapsulation portion covering the drive circuit.

9. The display baseplate according to claim 8, wherein the plurality of side surfaces are all selected side surfaces, the encapsulation layer comprises a first sub-encapsulation portion covering all the selected side surfaces and the second sub-encapsulation portion is ring-shaped.

10. The display baseplate according to claim 1, wherein the encapsulation layer is black.

11. A mould assembly for manufacturing a display baseplate, wherein the display baseplate comprises a backplate, a plurality of light emitters and an encapsulation layer, the backplate comprises a first main surface and a second main surface that are opposite to each other, and a plurality of side surfaces connected to the first main surface and the second main surface; the plurality of light emitters are located on the first main surface; and the encapsulation layer is at least partially located on the first main surface and covers the plurality of light emitters; the mould assembly comprises:

   a first sub-mould, comprising a first mould body and an auxiliary structure, wherein the auxiliary structure is disposed at a side of the first mould body, and is configured to fix the second main surface of the backplate to the first mould body; and
   a second sub-mould, comprising a second mould body, wherein an accommodation reservoir is disposed in the second mould body, the accommodation reservoir is configured to accommodate an encapsulation material for manufacturing the encapsulation layer; when the first sub-mould is fitted to the second sub-mould, an edge of the auxiliary structure is abutted against the second mould body to close the accommodation reservoir.

12. The mould assembly according to claim 11, wherein the auxiliary structure comprises a release film; or the auxiliary structure is a rigid structure.

13. The mould assembly according to claim 11, wherein the auxiliary structure comprises a flat plate portion and a boss structure located at a side of the flat plate portion away from the first mould body, an edge of the boss structure is located at an inner side of an edge of the flat plate portion; wherein the flat plate portion has a larger width than the accommodation reservoir, and the boss structure has a smaller width than the accommodation reservoir; wherein, when the first sub-mould is fitted to the second sub-mould, the edge of the flat plate portion is abutted against the second mould body and the boss structure enters the accommodation reservoir.

14. The mould assembly according to claim 11, wherein a drive circuit is disposed at an edge region of the second main surface; wherein a groove is disposed in an edge region of a surface of the auxiliary structure away from the first mould body and configured to enable an encapsulation material for manufacturing the encapsulation layer to partially enter between the groove and the second main surface of the backplate, so as to form a second sub-encapsulation portion covering the drive circuit.

15. The mould assembly according to claim 14, wherein the groove is ring-shaped groove.

16. A method for manufacturing a display baseplate, applied to the mould assembly of any one of claims 11 to 15, wherein the width of the backplate is less than the width of the accommodation reservoir; and the manufacture method comprises:

   fixing the second main surface of the backplate to a side of the auxiliary structure away from the first mould body and disposing a plurality of light emitters on the first main surface of the backplate;
   filling an encapsulation material for manufacturing the encapsulation layer in the accommodation reservoir of the second mould body;
   fitting the first sub-mould to the second sub-mould such that the edge of the auxiliary structure is abutted against the second mould body to close the accommodation reservoir, while the light emitters are immersed in the encapsulation material for manufacturing the encapsulation layer;
performing vacuumizaiton on the accommodation reservoir, and then, heating the first sub-mould and the second sub-mould such that the encapsulation material for manufacturing the encapsulation layer is thermally solidified to form an encapsulation layer at least partially covering the light emitters; and
releasing the first sub-mould and the second sub-mould to obtain the display baseplate.

17. A spliced display module, comprising a plurality of splicing units, wherein the plurality of splicing units comprise a splicing frame and the display baseplate of any one of claims 1 to 10, the display baseplate is fixed on the splicing frame with the light emitters away from the splicing frame; and the splicing frames of adjacent splicing units are spliced together.

18. The spliced display module according to claim 17, wherein a spacing between two adjacent light emitters in the display baseplate is a first spacing; in two adjacent splicing units, a spacing between a light emitter close to the edge of the display baseplate in one splicing unit and a light emitter closest to the light emitter in another splicing unit is a second spacing, and the first spacing is basically equal to the second spacing.

19. The spliced display module according to claim 17, wherein, in the splicing units, an edge of the encapsulation layer is located at an inner side of an edge of the splicing frame, and an edge of the backplate is located at an inner side of the edge of encapsulation layer.

20. The spliced display module according to claim 19, wherein, the spacing between adjacent light emitters in the display baseplate is the first spacing; in two adjacent splicing units, a light emitter closest to the other splicing unit in one splicing unit is a first light emitter, and a light emitter closest to the first light emitter in the other splicing unit is a second light emitter; a minimum distance between the first light emitter and the edge of the backplate of the display baseplate where the first light emitter is located is a first distance; a minimum distance between the second light emitter and the edge of the backplate of the display baseplate where the second light emitter is located is a second distance; in the display baseplate where the first light emitter is located, a minimum distance between the edge of the backplate closest to the first light emitter and the edge of the encapsulation layer is a third distance; in the display baseplate where the second light emitter is located, a minimum distance between the edge of the backplate closest to the second light emitter and the edge of the encapsulation layer is a fourth distance;

in two adjacent splicing units, a size D of a splicing gap between adjacent edges of the two encapsulation layers satisfies the following relational formula:

$$D \geq d_1 - S_1 - A_1 - S_2 - A_2 - 2\delta$$

wherein, $d_1$ is the first spacing, $S_1$ is the first distance, $S_2$ is the second distance, $A_1$ is the third distance, $A_2$ is the fourth distance, and $\delta$ is a maximum process deviation when thinning processing is performed on the side portion of the encapsulation layer; the sizes of the first spacing, the first distance, the second distance, the third distance, the fourth distance and the splicing gap are sizes in a same direction.

21. A display apparatus, comprising the display baseplate of any one of claims 1 to 10, or the spliced display module of any one of claims 17 to 20.

FIG.1

FIG.2

FIG.3

FIG.4

FIG.5

FIG.6

FIG.7

FIG.8

Fix the second main surface of the backplate to a side of the auxiliary structure away from the first mould body and the first main surface of the backplate is provided with a plurality of light emitters ⟋110

Fill an encapsulation material for manufacturing the encapsulation layer in the accommodation reservoir of the second mould body ⟋120

Fit the first sub-mould to the second sub-mould such that the edge of the auxiliary structure is abutted against the second mould body to close the accommodation reservoir, while the light emitter are immersed in the encapsulation material for manufacturing the encapsulation layer ⟋130

Perform vacuumizaiton on the accommodation reservoir, and then, heat the first sub-mould and the second sub-mould such that the encapsulation material for manufacturing the encapsulation layer is thermally solidified to form an encapsulation layer at least partially covering the light emitters ⟋140

Release the first sub-mould and the second sub-mould to obtain the display baseplate ⟋150

FIG.9

FIG.10

## INTERNATIONAL SEARCH REPORT

| International application No. |
| --- |
| **PCT/CN2022/095752** |

**A. CLASSIFICATION OF SUBJECT MATTER**

H01L 33/52(2010.01)i;  H01L 51/56(2006.01)i

According to International Patent Classification (IPC) or to both national classification and IPC

**B. FIELDS SEARCHED**

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

CNPAT, CNKI, EPODOC, WPI: 显示基板, 模具组件, 拼接, 背板, 发光单元, 封装层, 表面, 框, 基板, display, substrate, mold, assembly, tie, plate, light, emitting, unit, encapsulation, layer, surface, frame

**C. DOCUMENTS CONSIDERED TO BE RELEVANT**

| Category* | Citation of document, with indication, where appropriate, of the relevant passages | Relevant to claim No. |
| --- | --- | --- |
| X | CN 215527753 U (SHENZHEN JUFEI OPTOELECTRONICS CO., LTD.) 14 January 2022 (2022-01-14) description, paragraphs [0004]-[0055], and figures 1-12 | 1-4, 6-10, 17-21 |
| X | CN 214253720 U (UNILUMIN GROUP CO., LTD.) 21 September 2021 (2021-09-21) description, paragraphs [0037]-[0053], and figures 1-12 | 1-4, 6-10, 17-21 |
| X | CN 110838500 A (BRITISH CAYMAN ISLANDS SHANGNACHUANG TECHNOLOGY CO., LTD.) 25 February 2020 (2020-02-25) description, paragraphs [0042]-[0061], and figures 1-5 | 1-4, 6-10, 17-21 |
| Y | CN 215527753 U (SHENZHEN JUFEI OPTOELECTRONICS CO., LTD.) 14 January 2022 (2022-01-14) description, paragraphs [0004]-[0055], and figures 1-12 | 5, 11-16 |
| Y | CN 103531108 A (GUANGDONG VTRON TECHNOLOGIES LTD.) 22 January 2014 (2014-01-22) description, paragraphs [0060]-[0066], and figure 2 | 5 |
| Y | CN 109093909 A (SHENZHEN HOXLED OPTOELECTRONIC TECHNOLOGY CO., LTD.) 28 December 2018 (2018-12-28) description, paragraphs [0037]-[0039], and figures 7a-7d | 11-16 |

☑ Further documents are listed in the continuation of Box C.  ☑ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **11 December 2022** | **03 January 2023** |

| Name and mailing address of the ISA/CN | Authorized officer |
| --- | --- |
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

| International application No. |
|---|
| **PCT/CN2022/095752** |

| C. | DOCUMENTS CONSIDERED TO BE RELEVANT | |
|---|---|---|
| Category* | Citation of document, with indication, where appropriate, of the relevant passages | Relevant to claim No. |
| A | US 5889568 A (RAINBOW DISPLAYS INC.) 30 March 1999 (1999-03-30)<br>entire document | 1-21 |
| A | CN 107331790 A (BOE TECHNOLOGY GROUP CO., LTD.) 07 November 2017<br>(2017-11-07)<br>entire document | 1-21 |
| A | CN 215118140 U (BOE TECHNOLOGY GROUP CO., LTD.) 10 December 2021<br>(2021-12-10)<br>entire document | 1-21 |

Form PCT/ISA/210 (second sheet) (January 2015)

INTERNATIONAL SEARCH REPORT
Information on patent family members

International application No.

**PCT/CN2022/095752**

| Patent document cited in search report | | | Publication date (day/month/year) | Patent family member(s) | | | Publication date (day/month/year) |
|---|---|---|---|---|---|---|---|
| CN | 215527753 | U | 14 January 2022 | None | | | |
| CN | 214253720 | U | 21 September 2021 | WO | 2022166657 | A1 | 11 August 2022 |
| CN | 110838500 | A | 25 February 2020 | None | | | |
| CN | 103531108 | A | 22 January 2014 | None | | | |
| CN | 109093909 | A | 28 December 2018 | None | | | |
| US | 5889568 | A | 30 March 1999 | US | 6262696 | B1 | 17 July 2001 |
| CN | 107331790 | A | 07 November 2017 | None | | | |
| CN | 215118140 | U | 10 December 2021 | None | | | |

Form PCT/ISA/210 (patent family annex) (January 2015)